# EUROPÄISCHE PATENTSCHRIFT

(11) **EP 1 350 417 B1**
(45) Veröffentlichungstag und Bekanntmachung des Hinweises auf die Patenterteilung: **22.02.2006**
(21) Anmeldenummer: 01984815.9
(22) Anmeldetag: 10.12.2001
(51) Int. Cl.: H05K 3/00

(54) **VERFAHREN ZUR HERSTELLUNG EINER ELEKTRONISCHEN BAUGRUPPE**
METHOD FOR THE PRODUCTION OF AN ELECTRONIC COMPONENT
PROCEDE DE REALISATION D'UN MODULE ELECTRONIQUE

(30) Priorität: 13.01.2001 DE 10101359
(43) Veröffentlichungstag der Anmeldung: 08.10.2003
(73) Patentinhaber: Conti Temic microelectronic GmbH, 90411 Nürnberg (DE)
(72) Erfinder: HEINZ, Helmut, 91522 Ansbach (DE); NEHMEIER, Friedrich, 91085 Weisendorf (DE); SCHUCH, Bernhard, 91616 Neusitz (DE); TRAGESER, Hubert, 90409 Nürnberg (DE)
(86) Internationale Anmeldenummer: PCT/EP2001/014463
(87) Internationale Veröffentlichungsnummer: WO 2002/056652

(56) Entgegenhaltungen:
- WO-A-99/67978
- DE-A- 19 842 590
- DE-A- 19 909 505
- DE-C- 3 214 807
- PATENT ABSTRACTS OF JAPAN vol. 1999, no. 10, 31. August 1999 (1999-08-31) & JP 11 145592 A (SUMITOMO METAL SMI ELECTRON DEVICES INC), 28. Mai 1999 (1999-05-28)
- PATENT ABSTRACTS OF JAPAN vol. 018, no. 270 (E-1552), 23. Mai 1994 (1994-05-23) & JP 06 045734 A (NEC CORP), 18. Februar 1994 (1994-02-18)

## Beschreibung

In vielen Anwendungsbereichen der Elektrotechnik werden Schaltungsanordnungen mit elektronischen Bauteilen aufweisende elektronische Baugruppen eingesetzt, bei deren Betrieb eine hohe Verlustleistung auftritt; insbesondere ist dies bei elektronischen Baugruppen mit Leistungsbauteilen der Fall, wie bsp. bei Leistungsmodulen zur Ansteuerung elektronischer Komponenten oder weiterer Baugruppen. Die Bauteile der Schaltungsanordnung der elektronischen Baugruppe werden auf einen geeigneten Trägerkörper aufgebracht; bsp. werden bei Leistungsmodulen oftmals oberflächenmontierbare Leistungsbauteile verwendet, die mit ihrer rückseitigen Anschlußfläche auf einer Leiterplatte als Trägerkörper aufliegen.

Der Trägerkörper für die Bauteile der Schaltungsanordnung weist oftmals durchgängig metallisierte Durchkontaktierungen von der Oberseite zur Unterseite des Trägerkörpers auf: um eine elektrische Verbindung von der Oberseite des Trägerkörpers, d.h. von den Bauteilen der Schaltungsanordnung und der dort aufgebrachten metallischen Leitbahnstruktur, zur Unterseite des Trägerkörpers herzustellen, sind in den Trägerkörper elektrische Durchkontaktierungen (sog. elektrische vias) eingebracht; um eine ausreichende Wärmeabfuhr der Verlustleistung der Bauteile der Schaltungsanordnung zu gewährleisten (insbesondere der Verlustleistung von Leistungsbauteilen), können zur Unterstützung des vertikalen Wärmetransports in den Trägerkörper thermische Durchkontaktierungen (sog. thermische vias) eingebracht werden, die insbesondere direkt unter der rückseitigen Anschlußfläche (der Auflagefläche) der Bauteile (insbesondere der Leistungsbauteile) angeordnet sind.

Nach dem Aufbringen der Bauteile auf die Oberseite der Trägerplatte (die Bestükkungsseite) werden diese in einem Lötprozeß mit Anschlußflächen (Pads) und/oder Leiterbahnen der metallischen Leitbahnstruktur kontaktiert, bsp. indem Lotpaste auf die Anschlußflächen und die Oberfläche der Durchkontaktierungen gedruckt und in einem Reflow-Lötprozeß aufgeschmolzen wird. Hierbei können Lot oder Lotspritzer oder ebenfalls aufgeschmolzene Teile der metallischen Leitbahnstruktur aufgrund von Kapillareffekten durch die Durchkontaktierungen (vias) hindurch auf die Unterseite des Trägerkörpers gezogen werden und Schäden hervorrufen, bsp. eine auf der Unterseite des Trägerkörpers aufgebrachte elektrische Isolationsschicht beschädigen (bsp. eine Isolationsfolie durchstoßen) sowie elektrische Kurzschlüsse zu einem auf der Unterseite des Trägerkörpers optional vorgesehenen metallischen Kühlkörper hin oder zu einem den Trägerkörper und die Schaltungsanordnung umschließenden Gehäuse der elektronischen Baugruppe hin verursachen.

In der DE 198 42 590 A1 und der DE 199 09 505 A1 sind Verfahren zur Herstellung von Schaltungsanordnungen beschrieben, bei denen alle in den Trägerkörper eingebrachten thermischen Durchkontaktierungen (thermischen vias) von der der Oberseite (Bestückungsseite) des Trägerkörpers gegenüberliegenden Unterseite (Rückseite) des Trägerkörpers her mittels Siebdruck verschlossen werden. Hierbei wird der Durchmesser der thermischen Durchkontaktierungen an die jeweils angewandte Siebdrucktechnik angepaßt und so vorgegeben, daß eine ausreichende Bedeckung der thermischen vias innerhalb des Öffnungsvolumens stattfindet (bsp. kann eine bestimmte minimale Befüllung innerhalb der thermischen Durchkontaktierungen gefordert werden). Falls jedoch zur Realisierung der metallischen Leitbahnstruktur und der Metallisierung der Durchkontaktierungen aus Kostengründen oder wegen der besseren Handhabbarkeit Materialien mit geringem Schmelzpunkt (niederschmelzende Materialien) eingesetzt werden, können Probleme entstehen: die Metallisierung in den Durchkontaktierungen kann beim Lötprozeß zum Kontaktieren der Bauteile der Schaltungsanordnung aufschmelzen, so daß demzufolge das Siebdruckmaterial in den Durchkontaktierungen nicht mehr sicher verankert ist; auf der Unterseite des Trägerkörpers können hierdurch unerwünschte metallische Erhebungen entstehen, die die Funktion und Zuverlässigkeit der Schaltungsanordnung beeinträchtigen.

Der Erfindung liegt die Aufgabe zugrunde, ein einfaches Verfahren zur Herstellung einer elektronischen Baugruppe mit einem weiten Einsatzbereich und vorteilhaften Eigenschaften bezüglich der Wärmeabfuhr, der Zuverlässigkeit, der Kosten und des Herstellungsprozesses anzugeben.

Diese Aufgabe wird gemäß der Erfindung durch die Merkmale des Patentanspruchs 1 gelöst.

Vorteilhafte Ausgestaltungen der Erfindung sind Bestandteil der weiteren Patentansprüche.

Auf den Trägerkörper und auf die Bewandungen der zur Realisierung der elektrischen und thermischen Durchkontaktierungen (vias) vorgesehenen Durchführungen im Trägerkörper wird eine erste, die Grundmetallisierung bildende Metallisierungsschicht (vorzugsweise Kupfer) aufgebracht, wodurch Leitbahnstruktur (Leiterbahnen und Anschlußflächen) und Durchkontaktierungen ausgebildet werden.

Nach dem Aufbringen der die Grundmetallisierung bildenden ersten Metallisierungsschicht wird ein Siebdruckprozeß zum Einbringen von Siebdruckmaterial in die Durchkontaktierungen durchgeführt, wobei das zum Verschließen der Durchkontaktierungen vorgesehene Siebdruckmaterial von der Unterseite des Trägerkörpers her in die Öffnungen der (elektrischen und thermischen) Durchkontaktierungen auf die in die Durchführungen eingebrachte erste Metallisierungsschicht der Grundmetallisierung gedruckt wird. Hierzu werden hochviskose, thixotrope (pastöse), vorzugsweise lösungsmittelfreie Materialien verwendet, wobei das Siebdruckmaterial an das Material des Trägerkörpers angepaßt gewählt werden kann; insbesondere wird ein lösungsmittelfreies Feststoffepoxid (vorzugsweise ein lösungsmittelfreies Feststoffepoxidharz) mit minimaler Volumenreduktion beim Aushärten verwendet, so daß beim Aushärten keine Blasen oder Risse im Siebdruckmaterial entstehen können, die die Zuverlässigkeit des Verschlusses der Durchkontaktierungen beeinträchtigen würden. Beim Siebdruckprozeß wird um die Durchkontaktierungen herum ein Siebdruckfilm angeordnet und das Siebdruckmaterial zum Erzielen eines bestimmten Füllvolumens in einem mehrstufigen (mindestens zweistufigen) Druckvorgang von der Unterseite des Trägerkörpers her in die Öffnungen der Durchkontaktierungen eingedruckt, insbesondere mittels eines Naß-in-Naß erfolgenden mehrstufigen Siebdruckprozesses. Der Druckvorgang des Siebdruckmaterials in die Durchkontaktierungen wird hierbei so oft durchgeführt (mindestens jedoch zweimal hintereinander), bis ein bestimmtes Füllvolumen in den Durchkontaktierungen erreicht ist, d.h. eine gewünschte Dicke des Siebdruckmaterials in den Durchkontaktierungen und eine gewünschte flächenmäßige Bedeckung der Öffnungen der Durchkontaktierungen mit dem Siebdruckmaterial; hierbei muß nicht das gesamte Volumen der Durchkontaktierungen mit Siebdruckmaterial gefüllt werden, insbesondere sollten aber die Durchkontaktierungen in der Fläche vollständig mit Siebdruckmaterial bedeckt werden, in der Höhe sollte das Siebdruckmaterial mehr als die Hälfte der Höhe der Durchkontaktierungen und damit der Dicke des Trägerkörpers ausfüllen.

Nach der Prüfung des Verschlusses der Durchkontaktierungen (bsp. mittels optischer Kontrolle im Gegenlicht oder mittels eines automatisierten Vakuumtests mit der Bestimmung des Fremdluftanteils zur Erkennung evtl. vorhandener Löcher) wird der Trägerkörper getrocknet und das Siebdruckmaterial ausgehärtet.

Nach dem Druck und dem Aushärten des Siebdruckmaterials kann optional ein Reinigungsprozeß durchgeführt werden, bei dem auf dem Trägerkörper überstehende Reste des Siebdruckmaterials abgetragen werden; hierdurch werden einerseits plane und andererseits saubere (blanke) Oberflächen des Trägerkörpers geschaffen, die eine bessere Verarbeitung bei nachfolgenden Verfahrensschritten ermöglichen.

Vorteilhafterweise können hierzu beim Herstellungsprozeß der Schaltungsanordnung übliche Reinigungsprozesse eingesetzt werden, bsp. mechanische Reinigungsprozesse oder chemische Reinigungsprozesse.

Anschließend wird auf beide Oberflächenseiten des Trägerkörpers (auf die Oberseite und die Unterseite des Trägerkörpers) eine Passivierungsschicht als Korrosionsschutz ganzflächig aufgebracht, d.h. die Passivierungsschicht wird auf die die Grundmetallisierung bildende erste Metallisierungsschicht und auf das in den Durchkontaktierungen eingebrachte Siebdruckmaterial aufgebracht. Als Passivierungsschicht wird ein niederviskoses Material eingesetzt, insbesondere ein Lötstoplack, bsp. ein verdünntes, lösungsmittelhaltiges Feststoffepoxid (vorzugsweise ein lösungsmittelhaltiges Feststoffepoxidharz). Die Schichtdicke der bsp. durch ein Siebdruckverfahren oder durch ein Sprühverfahren aufgebrachten Passivierungsschicht wird anhand der Kriterien Wärmeleitung einerseits (Obergrenze für die Schichtdicke der Passivierungsschicht) und Bedeckung andererseits (Untergrenze für die Schichtdicke der Passivierungsschicht) gewählt, d.h. die Passivierungsschicht darf einerseits die Wärmeleitung (den thermischen Übergang) von der Oberseite zur Unterseite des Trägerkörpers nicht übermäßig beeinträchtigen, andererseits muß die Passivierungsschicht die die Grundmetallisierung bildende erste Metallisierungsschicht (auch an den Kanten der Öffnungen für die Durchkontaktierungen) vollständig bedecken.

Auf der Oberseite des Trägerkörpers wird die Passivierungsschicht in den für den Lötprozeß vorgesehenen Bereichen mittels eines selektiven Prozesses entfernt (bsp. werden diese Bereiche freigeätzt), insbesondere werden die Anschlußflächen der Leitbahnstruktur und die thermischen Durchkontaktierungen von der Passivierungsschicht befreit, so daß die die Grundmetallisierung bildende erste Metallisierungsschicht in diesen Bereichen freiliegt; die restlichen Bereiche der Oberseite des Trägerkörpers und die Unterseite des Trägerkörpers bleiben mit der Passivierungsschicht bedeckt, d.h. insbesondere sowohl die Unterseite des Trägerkörpers als auch die nicht für den Lötprozeß vorgesehenen Bereiche der Leitbahnstruktur (hier wirkt die Passivierungsschicht als Korrosionsschutz auf der die Grundmetallisierung bildenden ersten Metallisierungsschicht).

Zur Passivierung und zur Verbesserung der Lötbarkeit wird auf die von der Passivierungsschicht befreiten Bereiche auf der Oberseite des Trägerkörpers eine weitere Metallisierungsschicht aus einem Material mit geringem Schmelzpunkt (niederschmelzendem Material) aufgebracht, d.h. die dort freigelegte erste Metallisierungsschicht als Grundmetallisierung wird mit einer weiteren Metallisierungsschicht zur Bildung der (lötbaren) Endmetallisierung bedeckt. Bsp. wird auf die Kupferschicht der Grundmetallisierung mittels Heißluftverzinnung flüssiges Zinn aufgebracht, indem der Trägerkörper in flüssiges Zinn eingetaucht wird, wobei alle von der Passivierungsschicht befreiten Bereiche mit der weiteren Metallisierungsschicht bedeckt werden; anschließend kann der Trägerkörper und damit die aufgebrachte weitere Metallisierungsschicht zum Egalisieren der Oberfläche (bsp. mittels Druckluft) abgeblasen werden.

Auf die vollflächig mit der Passivierungsschicht bedeckte Unterseite des Trägerkörpers kann eine elektrische Isolationsschicht (insbesondere eine elektrisch isolierende, thermisch leitfähige Schicht) flächenbündig und luftspaltfrei aufgebracht werden, bsp. eine Schicht aus Wärmeleitpaste oder eine Folie als Isolationsfolie und Wärmeleitfolie. Zur externen Wärmeabfuhr kann der Trägerkörper auf einen metallischen Kühlkörper (bsp. eine Aluminiumplatte) aufgebracht werden, der die Verlustleistung der elektronischen Baugruppe an ein Kühlsystem weitergeben kann; hierbei kann der Trägerkörper über die elektrische Isolationsschicht potentialmäßig vom Kühlkörper getrennt werden.

Auf die Oberseite des Trägerkörpers werden nach dem Aufbringen der als Endmetallisierung vorgesehenen weiteren Metallisierungsschicht die Bauteile der Schaltungsanordnung aufgelötet (bsp. mittels eines Reflow-Lötprozesses); infolge des Verschlusses der Durchkontaktierungen und der sicheren Verankerung des zum Verschluß der Durchkontaktierungen vorgesehenen Siebdruckmaterials in den Durchkontaktierungen können Verunreinigungen der Unterseite des Trägerkörpers (insbesondere bedingt durch einen Lotdurchfluß von der Oberseite zur Unterseite des Trägerkörpers durch die Durchkontaktierungen hindurch) verhindert werden. Der Wärmetransport von der Oberseite zur Unterseite des Trägerkörpers wird durch das die Durchkontaktierungen verschließende Siebdruckmaterial und die auf der Unterseite des Trägerkörpers aufgebrachte Passivierungsschicht nicht beeinträchtigt.

Beim vorgestellten sicheren und einfachen Verfahren zur Herstellung einer elektronischen Baugruppe kann vorteilhafterweise mit geringen Kosten bei allen in den Trägerkörper eingebrachten (elektrischen und thermischen) Durchkontaktierungen ein Lotdurchfluß bei Lötprozessen (auch bei Mehrfachlötungen) durch die Durchkontaktierungen hindurch auch bei Verwendung von niederschmelzendem Material für die Metallisierung vollständig verhindert werden, unabhängig von der Ausgestaltung der Durchkontaktierungen (unabhängig von der Art der Durchkontaktierung), auch bei größeren Durchmessern der Durchkontaktierungen (bsp. bei einem Durchmesser der Durchkontaktierungen im Bereich von 0.2 mm bis 1.2 mm) und ohne Beeinträchtigung des thermischen Übergangs von der Oberseite zur Unterseite des Trägerkörpers (geringe thermische Impedanz an der Oberseite des Trägerkörpers). Gleichzeitig wird die Unterseite des Trägerkörpers für weitere Verfahrensschritte bei der Herstellung der elektronischen Baugruppe auf einfache Weise hergerichtet, bsp. für das Aufbringen einer Isolationsfolie und/oder eines Kühlkörpers. Weiterhin wird ein Korrosionsschutz für die die Grundmetallisierung bildende erste Metallisierungsschicht bereitgestellt.

Das Verfahren soll im folgenden anhand eines Ausführungsbeispiels im Zusammenhang mit der Zeichnung beschrieben werden.
Hierbei zeigt:

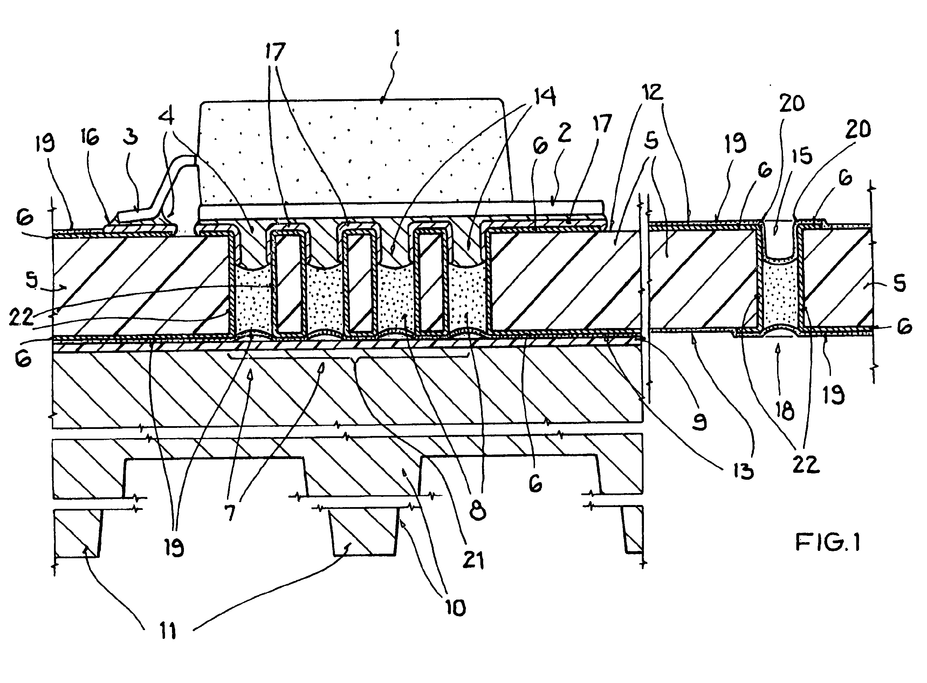

- Figur 1: eine Schnittdarstellung der elektronischen Baugruppe mit einem Ausschnitt der auf einem Trägerkörper aufgebrachten Schaltungsanordnung sowie mit Durchkontaktierungen von der Oberseite zur Unterseite des Trägerkörpers

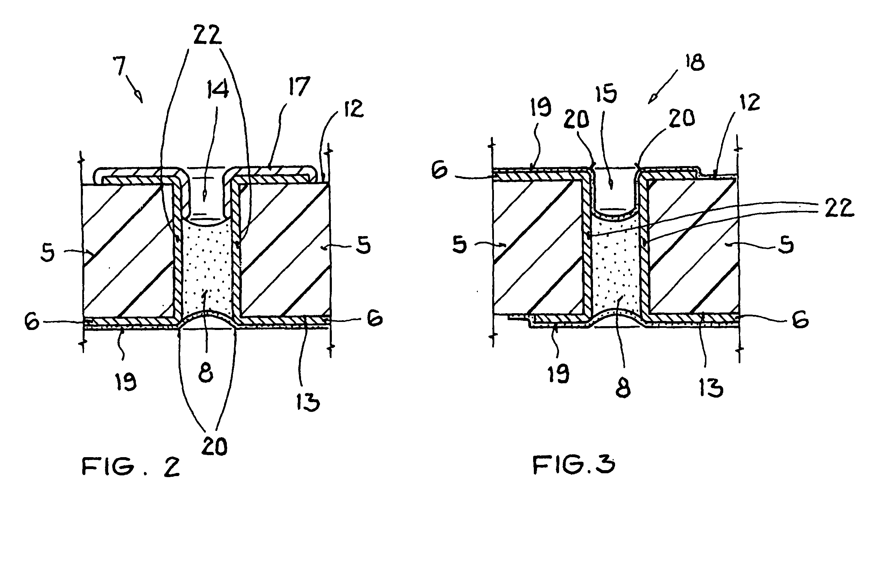

- Figur 2: eine Schnittdarstellung mit einer Detailansicht einer thermischen Durchkontaktierung
- Figur 3: eine Schnittdarstellung mit einer Detailansicht einer elektrischen Durchkontaktierung.

Die auf der Oberseite 12 eines bsp. als Leiterplatte ausgebildeten Trägerkörpers 5 angeordnete Schaltungsanordnung der elektronischen Baugruppe weist neben weiteren aktiven und passiven elektronischen Bauteilen auch mindestens ein Leistungsbauteil 1 auf, dessen Anschlußkontakte 3 mit der auf der Leiterplatte 5 aufgebrachten Leitbahnstruktur über die Anschlußfläche 16 kontaktiert werden sollen. Weiterhin sind sowohl elektrische Durchkontaktierungen 18 (elektrische vias) als auch thermische Durchkontaktierungen 7 (thermische vias) von der Oberseite 12 der Leiterplatte 5 zur Unterseite 13 der Leiterplatte 5 vorgesehen; die Durchkontaktierungen 7, 18 können hierbei bsp. einen Durchmesser von 0.2 mm bis 1.2 mm aufweisen. Bsp. sind zur Ausbildung der Durchkontaktierungen 7, 18 als Bohrungen ausgebildete Durchführungen in die Leiterplatte 5 eingebracht, deren Bewandungen 22 mittels einer (bsp. aus Kupfer bestehenden) zur Realisierung der Leitbahnstruktur vorgesehenen ersten Metallisierungsschicht 6 vollständig und ganzflächig belegt werden und deren Öffnungen 14, 1 5 nach dem Aufbringen der ersten Metallisierungsschicht 6 einen Durchmesser von bsp. 0.5 mm aufweisen. Die thermischen Durchkontaktierungen 7 sind hierbei jeweils in Arrays 21 angeordnet, wobei ein Array 21 bsp. ca. 64 thermische Durchkontaktierungen 7 auf einer Fläche von 9.5 mm x 9.5 mm umfaßt. Insbesondere ist mindestens ein derartiges Array 21 von thermischen Durchkontaktierungen 7 zum vertikalen Abführen der im Betrieb der elektronischen Baugruppe - insbesondere durch die Leistungsbauteile 1 der Schaltungsanordnung - entstehenden Verlustleistung im Bereich jedes der Leistungsbauteile 1 der Schaltungsanordnung vorgesehen. Hierzu liegen die Leistungsbauteile 1 mit ihrer Kühlfahne 2 auf der Oberseite 12 der Leiterplatte 5 auf den Öffnungen 14 der thermischen Durchkontaktierungen 7 auf, so daß ein effizienter Wärmeübergang von der Oberseite 12 der Leiterplatte 5 zur Unterseite 13 der Leiterplatte 5 ermöglicht wird. Von der Unterseite 13 der Leiterplatte 5 wird die Verlustleistung mittels des mit Kühlrippen 11 versehenen, bsp. als Kühlblech ausgebildeten metallischen Kühlkörpers 10 an ein Kühlsystem abgeführt. Zwischen der Unterseite 13 der Leiterplatte 5 und dem Kühlblech als Kühlkörper 10 ist zur elektrischen Isolation eine thermisch leitfähige, elektrisch isolierende Folie 9 (Isolationsfolie oder Wärmeleitfolie) angeordnet.

Bsp. sollen die Bauteile der Schaltungsanordnung auf die Oberseite 12 (Bestükkungsseite) der Leiterplatte 5 mittels eines Reflow-Lötprozesses aufgelötet werden. Um einen Durchfluß des Lots 4 von der Oberseite 12 der Leiterplatte 5 zur Unterseite 13 der Leiterplatte 5 beim Löten der Bauteile auf der Oberseite 12 der Leiterplatte 5 zu verhindern, werden die Durchkontaktierungen 7, 18 von der Unterseite 13 der Leiterplatte 5 her vor dem Lötprozeß und nach dem Aufbringen der ersten Metallisierungsschicht 6 als Grundmetallisierung (bsp. Kupfer mit einer Schichtdicke von 70 µm) einerseits auf die Oberfläche der Leiterplatte 5 zur Bildung der Leitbahnstruktur mit Leiterbahnen und Anschlußflächen und andererseits in die Öffnungen 14, 15 der Durchführungen zur Ausbildung der Durchkontaktierungen 7, 18 mittels eines Siebdruckprozesses verschlossen. Hierzu wird auf die Unterseite 13 der Leiterplatte 5 um die bsp. einen Durchmesser von 0.5 mm aufweisenden Öffnungen 14, 15 der Durchkontaktierungen 7, 18 herum ein Siebdruckfilm mit einem Durchmesser von bsp. 0.7 mm aufgebracht. Das Siebdruckmaterial 8, bsp. ein lösungsmittelfreies Feststoff-Epoxydmaterial, bsp. ein Feststoff-Epoxydharz, wird durch einen mehrstufigen Druckvorgang als Naß-in-Naß-Druck (bsp. durch einen zweistufigen Druckvorgang als Doppeldruck) derart von der Unterseite 13 der Leiterplatte 5 in die Öffnungen 14, 15 der Durchkontaktierungen 7, 18 gedruckt, daß ein bestimmtes Füllvolumen in den Öffnungen 14, 15 der Durchkontaktierungen 7, 18 erreicht wird, d.h. eine minimale Füllhöhe des Siebdruckmaterials 8 in den Durchkontaktierungen 7, 18 und eine minimale flächenmäßige Bedeckung der Öffnungen 14, 15 der Durchkontaktierungen 7, 18 (insbesondere soll die Fläche der Öffnungen 14, 15 der Durchkontaktierungen 7, 18 vollständig ausgefüllt sein und eine Füllhöhe von mindestens 50 % der Höhe der Öffnungen 14, 15 und damit der Dicke der Leiterplatte 5 erreicht werden), daß das ausgehärtete Siebdruckmaterial 8 keine Defekte (bsp. Einschlüsse, Luftblasen, Poren etc.) aufweist, und daß kein Siebdruckmaterial 8 durch die Öffnungen 14, 15 der Durchkontaktierungen 7, 18 hindurch fließt und die Oberseite 12 der Leiterplatte 5 (die Bestückungsseite) verunreinigt.

Nach dem Aushärten des Siebdruckmaterials 8 wird das sich auf der Oberfläche der Unterseite 13 und der Oberseite 12 der Leiterplatte 5 befindliche Siebdruckmaterial 8 (insbesondere das auf den Öffnungen 14, 15 und im Bereich der Öffnungen 14, 15 auf der Unterseite 13 und der Oberseite 12 der Leiterplatte 5 überstehende Siebdruckmaterial 8) mittels eines chemischen und/oder mechanischen Reinigungsprozesses entfernt, wobei als mechanischer Reinigungsprozeß bsp. das bei der Herstellung von Leiterplatten eingesetzte mechanische Bürstschleifen verwendet werden kann. Dieser Reinigungsprozeß wird bsp. 30 s lang durchgeführt, so daß das Siebdruckmaterial 8 vollständig abgetragen wird (bsp. ist noch ein maximaler Überstand des Siebdruckmaterials 8 auf der Oberfläche der Unterseite 13 der Leiterplatte 5 von 100 µm vorhanden); hierdurch wird die erste Metallisierungsschicht 6 für die weiteren Verfahrensschritte vorbereitet, ohne daß das sich in den Durchkontaktierungen 7, 18 befindliche Siebdruckmaterial 8 beeinträchtigt wird.

Auf die Oberseite 12 der Leiterplatte 5 und auf die Unterseite 13 der Leiterplatte 5 wird als Passivierungsschicht 19 ein Lötstoplack als Korrosionsschutz ganzflächig aufgebracht; der Lötstoplack 19 bedeckt somit sowohl die die Grundmetallisierung bildende erste Metallisierungsschicht 6 als auch das Siebdruckmaterial 8 in den Öffnungen 14, 15 der Durchkontaktierungen 7, 18 als auch die nicht von der ersten Metallisierungsschicht 6 bedeckten Bereiche der Leiterplatte 5. Als Lötstoplack 19 wird bsp. ein niederviskoses, verdünntes, lösungsmittelhaltiges Feststoffepoxidharz in einem Siebdruckverfahren, Vorhanggießverfahren oder Sprühverfahren aufgebracht; die Schichtdicke des Lötstoplacks 19 beträgt hierbei auf der Oberfläche der Oberseite 12 der Leiterplatte 5 und der Unterseite 13 der Leiterplatte 5 (einschließlich noch vorhandener Reste an Siebdruckmaterial 8) bsp. maximal 45 µm, an den Kanten 20 der Öffnungen 14, 15 der Durchkontaktierungen 7, 18 bsp. minimal 3 µm. Hierdurch wird einerseits ein ausreichender Wärmetransport von der Oberseite 12 der Leiterplatte 5 zur Unterseite 13 der Leiterplatte 5 und andererseits ein ausreichender Korrosionsschutz für die die Grundmetallisierung bildende erste Metallisierungsschicht 6 gewährleistet.

Auf der Oberseite 12 der Leiterplatte 5 wird der Lötstoplack 19 aus den für den Lötprozeß vorgesehenen Bereichen entfernt (bsp. durch einen selektiven Ätzprozeß), insbesondere aus den Öffnungen 14 der thermischen Durchkontaktierungen 7 und im Bereich der thermischen Durchkontaktierungen 7 sowie von den als Anschlußflächen 16 zum Auflöten und Kontaktieren der Bauteile 1 der Schaltungsanordnung vorgesehenen Bereichen; hierdurch liegt in diesen Bereichen die erste Metallisierungsschicht 6 frei an der Oberfläche. Auf alle zugänglichen Bereiche auf der Oberseite 12 der Leiterplatte 5 (auf die vom Lötstoplack 19 befreiten Bereiche auf der Oberseite 12 der Leiterplatte 5), d.h. auf die erste Metallisierungsschicht 6 als Grundmetallisierung, wird eine weitere Metallisierungsschicht 17 als Endmetallisierung aufgebracht, bsp. eine flüssige Zinn-Blei-Legierung mittels Heißluftverzinnung; hierbei wird die Leiterplatte 5 in ein Bad mit einer Mischung aus flüssigem Zinn und

Blei eingetaucht, wobei alle ungeschützten, nicht vom Lötstoplack 19 bedeckten Bereiche auf der Oberseite 12 der Leiterplatte 5 mit der weiteren Metallisierungsschicht 17 bedeckt werden (bsp. weist diese weitere Metallisierungsschicht 17 eine Schichtdicke von 1 µm bis 40 µm auf). Durch Abblasen mit Druckluft wird die Oberfläche der weiteren Metallisierungsschicht 17 planarisiert.

Auf die Unterseite 13 der Leiterplatte 5 wird eine elektrisch isolierende, thermisch leitfähige Folie 9 bündig und vollflächig aufgebracht, bsp. eine Wärmeleitfolie mit einer Dicke von 150 µm. Weiterhin ist auf der Unterseite 13 der Leiterplatte 5 der mit Kühlrippen 11 versehene, als Kühlblech ausgebildete metallische Kühlkörper 10 angeordnet, der zur elektrischen Isolation von der Leiterplatte 5 durch die Isolationsfolie 9 separiert ist.

Die Bauteile 1 der Schaltungsanordnung werden auf die Oberseite 12 (Bestükkungsseite) der Leiterplatte 5 bsp. mittels eines Reflow-Lötprozesses aufgelötet; hierbei werden durch das Lot 4 die nicht vom Siebdruckmaterial ausgefüllten Bereiche der Öffnungen 14, 15 der Durchkontaktierungen 7, 18 aufgefüllt (ohne daß Lot 4 von der Oberseite 12 der Leiterplatte 5 zur Unterseite 13 der Leiterplatte 5 gelangen kann) und die Bauteile 1 der Schaltungsanordnung mit den Anschlußflächen 16 und damit mit der Leitbahnstruktur elektrisch leitend verbunden.

## Patentansprüche

1. Verfahren zur Herstellung einer elektronischen Baugruppe mit einer auf einem Trägerkörper (5) aufgebrachten Schaltungsanordnung mit mindestens einem elektronischen Bauteil (1), mit folgenden Verfahrensschritten:
a) Einbringen von Durchführungen in den Trägerkörper (5),
b) Aufbringen einer ersten, die Grundmetallisierung bildenden Metallisierungsschicht (6) auf den Trägerkörper (5) zur Ausbildung einer Leitbahnstruktur und in die Öffnungen (14, 15) der Durchführungen zur Ausbildung thermischer Durchkontaktierungen (7) und elektrischer Durchkontaktierungen (18),
c) Verschließen der Durchkontaktierungen (7, 18) von der Unterseite (13) des Trägerkörpers (5) her mittels eines Siebdruckprozesses mit hochviskosem Siebdruckmaterial (8),
d) Aufbringen einer niederviskosen Passivierungsschicht (19) ganzflächig auf die Oberseite (12) und die Unterseite (13) des Trägerkörpers (5),
e) selektives Entfernen der Passivierungsschicht (19) auf der Oberseite (12) des Trägerkörpers (5) in bestimmten Bereichen,
f) Aufbringen einer zweiten, die Endmetallisierung bildenden Metallisierungsschicht (17) aus einem Material mit niedrigem Schmelzpunkt in den von der Passivierungsschicht (19) befreiten Bereichen auf die erste Metallisierungsschicht (6),
g) Aufbringen und Kontaktieren des mindestens einen elektronischen Bauteils (1) der Schaltungsanordnung auf der Oberseite (12) des Trägerkörpers (5) durch einen Lötprozeß.

2. Verfahren nach Anspruch 1, **dadurch gekennzeichnet, daß** die auf der Unterseite (13) und /oder auf der Oberseite (12) des Trägerkörpers (5) überstehenden Reste des Siebdruckmaterials (8) nach dem Siebdruckprozeß und dem Aushärten des Siebdruckmaterials (8) durch mindestens einen Reinigungsprozeß abgetragen werden.

3. Verfahren nach Anspruch 1, **dadurch gekennzeichnet, daß** als niederviskose Passivierungsschicht (19) ein Lötstoplack ganzflächig auf die Oberseite (12) und die Unterseite (13) des Trägerkörpers (5) aufgebracht wird.

4. Verfahren nach einem der Ansprüche 1 bis 3, **dadurch gekennzeichnet, daß** das mindestens eine elektronische Bauteil (1) der Schaltungsanordnung durch einen Reflow-Lötprozeß auf der Oberseite (12) des Trägerkörpers (5) aufgebracht und kontaktiert wird.

5. Verfahren nach einem der Ansprüche 1 bis 4, **dadurch gekennzeichnet, daß** auf die Unterseite (13) des Trägerkörpers (5) eine thermisch leitfähige, elektrisch isolierende Folie (9) aufgebracht wird.

6. Verfahren nach einem der Ansprüche 1 bis 5, **dadurch gekennzeichnet, daß** die thermisch leitfähige, elektrisch isolierende Folie (9) mit einem Kühlkörper (10) verbunden wird.

## Claims

1. Method for manufacturing an electronic assembly with a circuit arrangement mounted on a carrier body (5) with at least one electronic component (1) comprising the following steps:
a) providing the carrier body (5) with ducts;
b) coating the carrier body (5) and the openings (14, 15) of the ducts with a first metallization layer (6) (basic metallization), wherein this coating process is carried out for the purpose of forming a track structure on the carrier body (5) and forming thermal vias (7) and electrical vias (18) in the openings (14, 15);
c) sealing the vias (7, 18) in a screen-printing process starting from the bottom (13) of the carrier body (5) and using very viscous screen-printing material (8);
d) coating the top (12) and the bottom (13) of the carrier body (5) completely with a passivation layer (19) comprising low viscosity;
e) removing the passivation layer (19) selectively from particular portions of the top (12) of the carrier body (5);
f) coating the first metallization layer (6) with a second metallization layer (17) (final metallization) in those portions from which the passivation layer (19) has been removed, wherein the material of the second metallization layer (17) comprises a low melting point;
g) mounting and bonding the at least one electronic component (1) of the circuit arrangement onto/on the top (12) of the carrier body (5) in a soldering process.

2. Method according to claim 1, **characterized in that** the rests of the screen-printing material (8) projecting over the bottom (13) and/or the top (12) of the carrier body (5) are removed in at least one cleaning process carried out after the processes of screen printing and curing the screen-printing material (8).

3. Method according to claim 1, **characterized in that** the low-viscosity passivation layer (19) with which the top (12) and the bottom (13) of the carrier body (5) are completely coated is a solder resist.

4. Method according to any one of claims 1 to 3, **characterized in that** the at least one electronic component (1) of the circuit arrangement is mounted and bonded onto/on the top (12) of the carrier body (5) by reflow soldering.

5. Method according to any one of claims 1 to 4, **characterized in that** the bottom (13) of the carrier body (5) is coated with a thermally conductive, electrically insulating sheet (9).

6. Method according to any one of claims 1 to 5, **characterized in that** the thermally conductive, electrically insulating sheet (9) is connected to a heat sink (10).

## Revendications

1. Procédé pour la fabrication d'un assemblage électronique avec une disposition de circuit placé sur un élément support (5), avec au moins un composant électronique (1), avec les étapes de procédé suivantes :
a) réalisation de traversées dans l'élément support (5),
b) pose d'une première couche de métallisation (6), constituant la métallisation de base, sur l'élément support (5) pour la formation d'une structure de pistes conductrices et dans les ouvertures (14, 15) des traversées pour la formation de connexions transversales thermiques (7) et de connexions transversales électriques (18),
c) obturation des connexions transversales (7, 18) à partir de la face inférieure (13) de l'élément support (5), au moyen d'un processus de sérigraphie avec matériau d'impression (8) à haute viscosité,
d) pose d'une couche de passivation (19) à faible viscosité sur toute la surface sur la face supérieure (12) et sur la face inférieure (13) de l'élément support (5),
e) enlèvement sélectif de la couche de passivation (19) sur la face supérieure (12) de l'élément support (5) dans des zones déterminées,
f) pose d'une seconde couche de métallisation (17), constituant la métallisation finale, se composant d'un matériau avec point de fusion bas, dans les zones libérées de la couche de passivation (19) sur la première couche de métallisation (6),
g) pose et connexion d'au moins un composant électronique (1) de la disposition de circuit sur la face supérieure (12) de l'élément support (5) par un processus de soudage.

2. Procédé selon la revendication 1, **caractérisé en ce que** les restes de matériau d'impression (8) se trouvant encore sur la face inférieure (13) et/ou sur la face supérieure (12) de l'élément support (5) après le processus de sérigraphie et ia solidification du matériau d'impression (8) sont ôtés au moyen d'au moins un processus de nettoyage.

3. Procédé selon la revendication 1, **caractérisé en ce qu'**un vernis épargne est posé sur toute la surface sur la face supérieure (12) et sur la face inférieure (13) de l'élément support (5), comme couche de passivation (19) à faible viscosité.

4. Procédé selon les revendications 1 à 3, **caractérisé en ce qu'**au moins un composant électronique (1) de la disposition de circuit est posé et connecté par un processus de soudage par refusion sur la face supérieure (12) de l'élément support (5).

5. Procédé selon les revendications 1 à 4, **caractérisé en ce qu'**une feuille (9) thermoconductrice, électriquement isolante, est placée sur la face inférieure (13) de l'élément support (5).

6. Procédé selon les revendications 1 à 5, **caractérisé en ce que** la feuille (9) thermoconductrice, électriquement isolante, est reliée à un dissipateur thermique (10).
